**Europäisches Patentamt**

**European Patent Office**

**Office européen des brevets**

(11) Publication number: **0 039 921**

**B1**

## (12) EUROPEAN PATENT SPECIFICATION

(45) Date of publication of patent specification: **08.05.85**

(51) Int. Cl.⁴: **G 01 D 5/249, H 03 M 1/22**

(21) Application number: **81103499.0**

(22) Date of filing: **07.05.81**

(54) Encoder device and method of use of it.

(30) Priority: **12.05.80 JP 62411/80**

(43) Date of publication of application:
**18.11.81 Bulletin 81/46**

(45) Publication of the grant of the patent:
**08.05.85 Bulletin 85/19**

(84) Designated Contracting States:
**CH DE FR GB LI SE**

(56) References cited:
**EP-A-0 013 799**
**US-A-4 074 258**

(73) Proprietor: **TOKYO KOGAKU KIKAI KABUSHIKI KAISHA**
**75-1, Hasunuma-cho Itabashi-ku**
**Tokyo (JP)**

(72) Inventor: **Minami, Masana**
**2-6-8-403, Nagao**
**Tama-ku, Kawasaki-shi (JP)**
Inventor: **Ohtomo, Fumio**
**301-39, Sunashinden**
**Kawagoe-shi, Saitama-ken (JP)**
Inventor: **Kimura, Kazuaki**
**2-24-16, Nishidai**
**Itabashi-ku, Tokyo (JP)**

(74) Representative: **Fleuchaus, Leo, Dipl.-Ing. et al**
**Fleuchaus & Wehser Melchiorstrasse 42**
**D-8000 München 71 (DE)**

## Description

The present invention relates to an improvement in a method and a device for measuring a linear displacement or a rotation angle.

For measuring by remote control a distance of displacement or a rotation angle of a moving object from a reference point, a scale is mounted to the object while a sensor is utilized which outputs an output signal when the scale has passed in front of it, thereby counting the number of the output signals thus output from the reference point of the scale.

However, since the above-mentioned measuring method is the so-called incremental method which measures according to the relative displacement between the scale and the sensor, the relative relations of the scale and the sensor must be set in advance so that the count becomes zero when the reference point of the scale is in front of the sensor.

In order to eliminate such an inconvenience, an absolute method has been proposed according to which the scale is encoded. According to this method, a code plate is used as the scale and is calibrated by encoding the distance from the reference point. Thus, the distance from the reference point is measured by reading it directly. According to this method, the initial setting can be simplified, since the distance from the reference point of the scale opposing the sensor may be readily measured.

However, when the absolute method is adopted, the pattern codes representing the distances from the reference point must be marked on the scale. These pattern codes generally comprise a plurality of tracks, requiring a corresponding number of sensors. This results in a complex and expensive device.

US—A—4,074,258 discloses an encoder which solves the problems of the conventional encoders. This encoder comprises a scale having coded references, such as an identification bit and interpolation mark, which are distributed at equal intervals along displacement direction of the scale, and a linear matrix of sensor elements for detecting the coded references. The upper significant digit of the amount of relative displacement between the scale and the linear matrix is identified by detecting the identification bit. The lower significant digit is identified by measuring the distance between one end of the linear matrix of the sensor elements and the interpolation mark, using the length of the individual elements as a unit of length. With such a method and device, when any noise component (e.g., dust or a defect in the line sensor) is present on the interpolation mark or on the line sensor on which is projected the interpolation mark, the interpolation mark may not be accurately detected, resulting in an error in the readings of the lower significant digits.

The present invention has been made in consideration of this and has as its object to provide an encoder device which adopts the absolute method and which is inexpensive and simple in construction.

Another object of the invention is to provide an encoder device with high precision and reliability against the noise component.

The features of the invention are set out in the method claims 1 and 2 and in the device claim 4.

This invention can be more fully understood from the following detailed description when taken in conjunction with the accompanying drawings, in which:

Figure 1 shows an example combining a charge effect type sensor with a scale having a light-dark pattern;

Figures 2A to 2D show waveforms obtained when the charge effect type sensor of the arrangement shown in Figure 1 is scanned;

Figure 3 is a view for explaining the principle of the present invention which combines a charge effect type sensor and a scale having a light-dark pattern for measuring lengths;

Figure 4 shows the construction of the encoder device;

Figure 5 is a flow chart for explaining the mode of operation of the encoder device shown in Figure 4; and

Figure 6 shows the construction of the scale used in an encoder device according to an embodiment of the present invention.

A scale is used which records codes consisting of "0" and "1" obtained by encoding a length or angle from a reference point, and a sensor for reading the codes of the scale comprises a line sensor in which a plurality of sensor elements are arranged at equal intervals.

As such a line sensor are known charge effect type sensors which perform self-scanning, among which is particularly well known a CCD line sensor. Therefore, the principle of the present invention in which a CCD line sensor is used as the above-mentioned sensor will first be described, and the present invention will then be described with reference to its preferred embodiments.

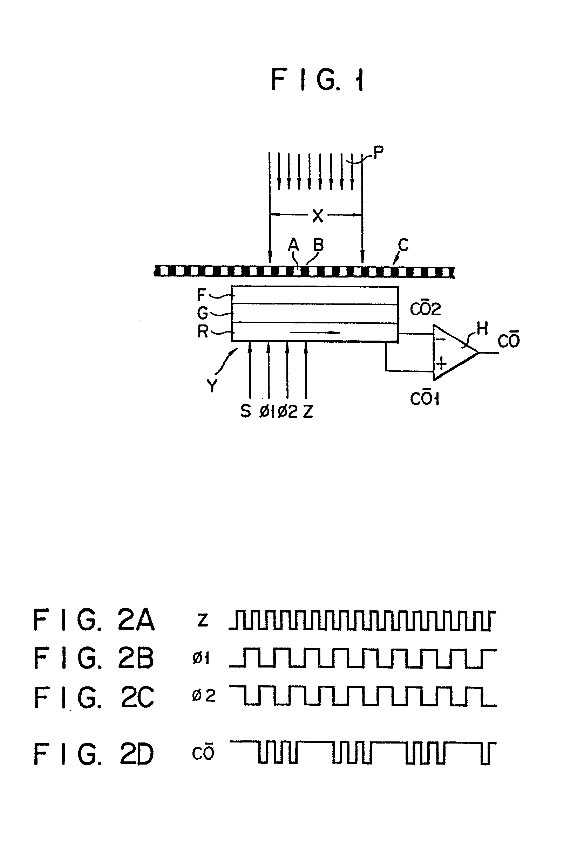

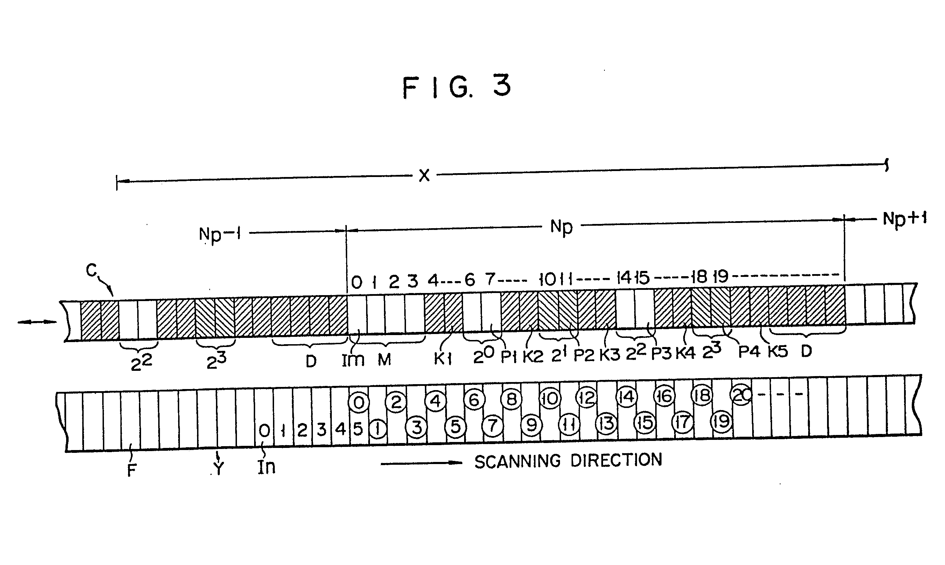

A charge effect type sensor, as may be typically represented by a charge coupled device (CCD), comprises a photoelement part, a gate part, and a shift register part. The photoelement part includes a number of elements arranged linearly. Each of these elements has a function to store a charge corresponding to the product of the time and the illuminance of the incident light thereon. The shift register has the same number of bits as the elements in the photoelement part. To each bit is transferred the charge on the corresponding element through the gate part parallel to each other. When a scanning pulse is supplied, the charges on the respective bits are time-serially output. With such a charge effect type sensor, the width of the respective elements constituting the photoelement part may be set to the order of less than about 15 microns, so that high precise measurements may be possible. As shown in Figure 1, a charge effect type sensor such as a CCD Y consisting of a photoelement part F, a gate part G, and a shift register part R is opposed to one surface of a scale C with linearly alternating light parts A (transparent) and dark parts B (opaque). When parallel light rays P forming a beam of width X are irradiated on the opposite surface of the scale C, the light transmitted through the light part A becomes incident on the photoelement F. The charge corresponding to the light incident on the element is stored on this element. When a gate pulse S as well as a resetting pulse Z (Figure 2A) and scanning pulses $\phi1$ (Figure 2B) and $\phi2$ (Figure 2C), which are obtained by frequency-dividing this pulse Z by 1/2 and which have a mutual phase difference of 180°, are supplied to the CCD Y, an output $\overline{CO}$ as shown in Figure 2D is output from a differential amplifier H. A signal $\overline{CO}1$ from the photoelement part containing the noise of the shift register part or the like and a signal $\overline{CO}2$ containing only the noise are obtained as the output of the CCD Y of the construction described above. Thus, the noise component $\overline{CO}2$ must be removed from the singal $\overline{CO}$ by the differential amplifier H. For the sake of simplicity, only the output $\overline{CO}$ of the differential amplifier will be referred to as the CCD output. Figure 2D shows a case wherein the width of the light part A is set to equal three elements constituting the photoelement part F, and the three elements are opposed to the light part A. In this case, the differential amplifier H time-serially outputs three signals in a group in correct correspondence with the above-mentioned opposing relationship. It thus becomes possible, with the combination of a charge effect type sensor and a scale coding the distance from a reference point with a light-dark pattern, to measure the distance from the reference point of the scale, that is, the length, with a precision of about 15 microns or less. According to the present invention, the scale and the sensor are arranged in a manner as shown in Figure 3. Thus, the scale C is divided into a plurality of blocks of equal length arranged in the longitudinal direction. Referring to this figure, only the $N_p$th block and $N_{p-1}$th block are shown. Describing the structure of each block by taking the $N_p$th block as an example, at the left end of the $N_p$th block is a marker M in the form of a light part and having a width corresponding to four elements of the photoelement part F, the width for one element being the reference width. At the right end part of the adjacent block $N_{p-1}$ is formed a block stop marker D comprising the dark part corresponding to four elements of the CCD Y. The width of one element of the marker M which is adjacent thereto is referred to as a marker bit Im. To the right of the marker M are formed dark parts K1, K2, K3, . . ., each of a width corresponding to two elements at intervals corresponding to a width of two elements. Between these dark parts are formed address parts P1, P2, P3, . . . each of a width corresponding to two elements. The address part P1 corresponds to a binary code $2^0$, the address part P2 corresponds to a binary code $2^1$, the address part P3 corresponds to a binary code $2^2$, and so on. In the figure, the address parts P1 and P3 are light parts and the other address parts are dark parts. Although the construction of the block $N_{p-1}$ is similar to that described above with reference to the case of the block $N_p$, the values of the binary codes for the address parts are all subtracted by 1 from the corresponding values for the block $N_p$.

For measuring with high precision a distance from the reference point of the scale C with such a combination of the scale C and the CCD Y, the following procedure is followed.

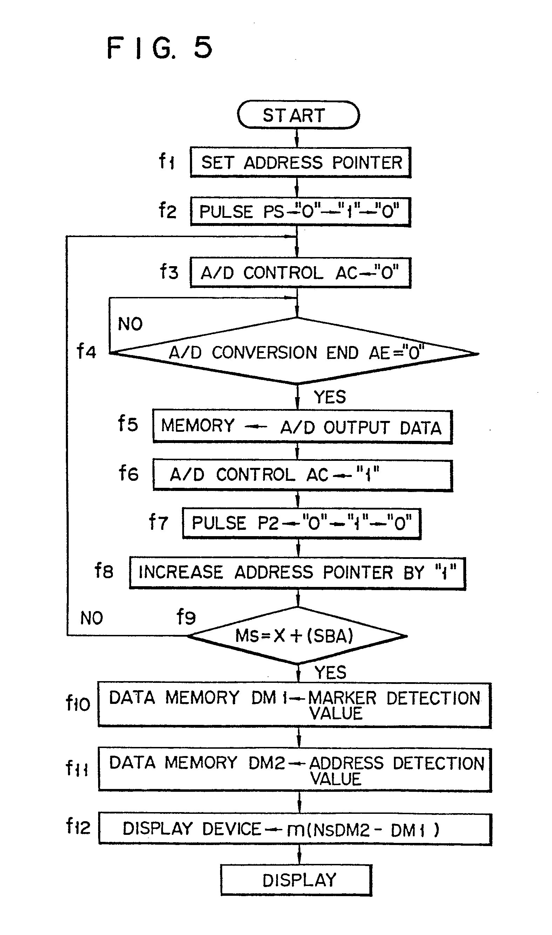

The respective elements of the photoelement part F of the CCD Y are provided with bit numbers as shown in the figure. More precisely, serial bit numbers are given to the elements arranged behind the element which corresponds to the marker bit Im detected, in the same way as at label $F_{10}$ of the flow chart shown in Figure 5 which will be later described. A particular bit is designated as an index bit In. The scale C is irradiated with parallel light rays forming a beam of width X which is substantially equal to the width of two blocks, and the light-receiving conditions of the ⑥ and ⑦ bits, ⑩ and ⑪ bits, ⑭ and ⑮ bits, ⑱ and ⑲ bits and so on are first detected. In this example, the ⑥ and ⑦ bits are ON so that the $2^0$ digit is ON. The ⑩ and ⑪ bits are OFF, so the $2^1$ digit is OFF. Similarly, the ⑭ and ⑮ bits are ON and the $2^2$ digit is ON. The ⑱ and ⑲ bits are OFF, so the $2^3$ digit is OFF. Thus, the absolute address of the block $N_p$ may be obtained as $2^2+2^0=5$. It is seen from this that the block $N_p$ is the fifth block from the reference point of the scale. When one block is of 26 bit construction and the width of one bit is set to 15 μ, the width of one block is obtained as 15μ×26=0.39 mm. Therefore, it is seen that the block $N_p$ is spaced apart from the reference point by 0.39 mm×5=1.95 mm. For obtaining a more precise distance measurement, the number of bits from the index bit In to the bit opposing the marker bit Im is counted. In this case, since the number of bits is 5, the correct distance may be obtained as

$$1.95 \text{ mm}-15\mu\times5=1.875 \text{ mm}$$

Therefore, the measurement E may be expressed as

$$E=m(Ns \cdot ACD-Nc) \text{ (unit: μ)}$$

where Nc=number of bits from the index bit In to the marker bit Im
ACD=block address
Ns=length of one block as represented by the number of elements of photoelement part F
mμ=width of one element

This value E is obtained in the case wherein the address of the block whose marker is located to the right of the index bit is measured, as shown in Figure 3. However, when measuring the address of the block which is to the left of the index bit In, the measurement E may be expressed as

$$E=m(Ns \cdot ACD+Nc)$$

With a combination of a scale having a light-dark pattern and a charge effect type sensor, a distance, that is, a length, may be measured with a simple and inexpensive structure without detecting the reference point. This also applies to the measurement of angles.

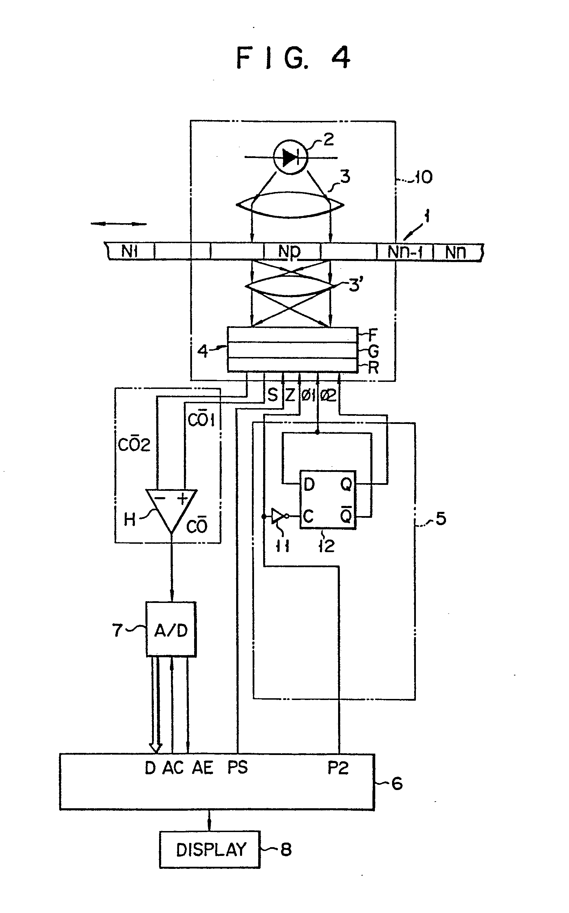

Referring to Figure 4, reference numeral 1 denotes a linear scale mounted to a moving object (not shown). This scale 1 is divided into n blocks of the same length in the longitudinal direction as the blocks shown in Figure 3. As in the case of Figure 3, each block includes, in the form of a pattern, the marker M, the stop marker D, and the address parts P1, P2, . . . .

At one side of the scale is arranged a light source 2 comprising a light emitting diode, for example. The light emitted from the light source 2 is converted into parallel light rays by a lens system 3 and the scale 1 is irradiated with this light. At the other side of the scale 1 is disposed a charge effect type sensor, a CCD 4 for example, for detecting the light transmitted through the scale 1 via another lens system 3'. The CCD 4 comprises, as has already been described, the photoelement part F consisting of a plurality of elements, the gate part G, and the shift register part R. When the gate pulse S is supplied the charge stored on the photoelement part F is transferred to the shift register part R. When the resetting pulse Z as well as the scanning pulses $\phi 1$ and $\phi$ obtained by 1/2 frequency-dividing and having a mutual phase difference of 180° are supplied to the shift register part R, its content is time-serially output. The driving status of the CCD 4 is controlled by a microcomputer 6 through a pulse control circuit 5. An output $\overline{CO}$ of the CCD 4 is processed by the microcomputer 6 through an A/D converting circuit 7 and is displayed at a display device 8. The light source 2, the lens systems 3 and 3', and the CCD 4 are assembled within a box body 10 and are fixed such that the scale 1 is interposed between the parts without contacting them.

The pulse control circuit 5 described above is constructed in the manner described below. A pulse P2 supplied from the microcomputer 6 in a manner to be described below is supplied to the CCD 4 as the resetting pulse Z as well as to a clock terminal C of a flip-flop circuit 12 (a flip-flop which is rendered operative by the leading edge of the clock signal) through an inverter 11. This flip-flop circuit 12 is a T-flip-flop having an output $\overline{Q}$ supplied to an input terminal D of the flip-flop circuit 12. The output $\overline{Q}$ is supplied to the CCD 4 as the scanning pulse $\phi 1$ and an output Q is supplied as the scanning pulse $\phi 2$.

The A/D converting circuit 7 is cleared when an A/D control terminal AC of the microcomputer 6 is at level "1" and performs A/D conversion when it is at level "0". When the A/D conversion is terminated, a terminal AE of the microcomputer 6 which has been maintained at "1" during the operative condition is changed to "0".

Thus, the encoder device of the construction described above operates according to a program set in the microcomputer 6.

The microcomputer 6 comprises a micro CPU (central processing unit), a line memory for storing an A/D converted output of the CCD 4, data memories for storing operation results of the micro CPU, and a program memory for storing a program. The micro CPU comprises a general CPU which comprises an arithmetic and logic unit, a set of general registers, a control part and so on.

The operation of the micro CPU will be described with reference to the flow chart shown in Figure 5. When the program is started, the following operations are performed:

f1: An initial address SDA of the line memory ($M_{SDA}$ to $M_{SDA+x-1}$) for storing the A/D converted output of the CCD 4 is set in one of the general registers of the micro CPU. This register is defined as the address pointer of the line memory ($M_{SDA}$ to $M_{SDA+x-1}$), where X stands for the number of elements of the CCD which are to be stored in the line memory. For instance, when the CCD 4 has 1,728 elements and the information for all the elements is to be stored, X is 1,728.

f2: One pulse Ps is generated ("0"→"1"→"0"). Upon this operation, charge is transferred from the photoelement part F to the shift register part R.

f3: The A/D control terminal AC is set at "0". Upon this operation, the A/D converting circuit 7 starts A/D conversion.

f4: The program is sustained until A/D conversion termination terminal AE is at "0".

f5: A/D output data D is written in the line memory represented by the address pointer.

f6: The A/D control terminal AC is set at "1". The A/D converting circuit 7 is cleared.

f7: One pulse P2 is generated ("0"→"1"→"0"). The shift register part R of the CCD 4 is shifted by 1 bit.

f8: The content of the address pointer is incremented by "1".

f9: It is checked whether the content of the address pointer has become SDA+X, that is, whether the data of required number X has been obtained. When the content takes this particular value, a judgment of "YES" is made.

f10: The contents of the line memory are sequentially scanned from the address corresponding to the index bit In (Figure 3) of the CCD 4 to the remaining addresses. Each content is judged as to whether it is greater or smaller than a suitable threshold value, for example, 50% of the output level of the light part. Suppose five or more black elements (less than the threshold value) are followed by three or more white elements (greater than the threshold value). In this case, the first of the three or more white elements is judged to be the marker bit Im (Figure 3). The number of bits existing between Index bit and the marker bit Im is counted. In the case of Figure 3, the number of bits is 5. This value is written in a data memory DM1.

f11: With reference to the marker bit Im, it is checked whether the respective bits corresponding to the address encoded on the scale are white or not to obtain the block address of the scale 1. This block address is written in a data memory DM2.

f12: The distance E from the reference point is calculated by the equation

$$E = m(Ns \cdot DM2 - DM1)$$

where Ns is the number of bits of one block as represented by the number of elements of the photoelement part of the CCD 4, and m is the element pitch. DM1 and DM2 here are the contents of the data memories DM1 and SM2. Thus, the distance E from the reference point is displayed at the display device 8.

Thus, a scale is adopted which encodes the distance from a reference point with a light-dark pattern, and a charge effect type sensor represented by a CCD is adopted as a sensor for reading the pattern codes of the scale. Since the width of each element constituting the photoelement part of the charge effect type sensor may be set to less than about 15 microns as has been already described, the pattern codes may be read to the order of less than 15 microns with relatively sparse pattern codes. Accordingly, a high precision may be accomplished with the absolute method while allowing a simple and inexpensive construction.

The upper significant digit of each block is identified by detecting the recorded address of the block. The lower significant digit of each block is identified by measuring the distance between the marker bit position and a reference position, using the length of individual elements as a unit of length. Here, the marker bit position is identical with the photoelement on which there is projected a pattern, e.g. a marker bit Im (Figure 3), put on each block at a predetermined position. The reference position is identical with any one of the photoelements. With such a method, when any noise component is present on the marker bit Im or the line sensor on which is projected the marker bit Im, (dust or a defect in the line sensor, for example), the correct detection of the marker bit Im is impaired, resulting in an error in the readings of the lower significant digits. A second embodiment of a reading method of the present invention will now be described according to which the error factor as described above is taken into consideration and a more reliable reading is provided.

The said embodiment will be described with reference to Figure 3. According to this embodiment, a code plate similar to that used in Figure 3 is used, although the functions of the marker M and the marker bit Im are significantly different from those of the first embodiment. According to the second embodiment, the marker M and the marker bit Im are used only for identification of the positions of the respective patterns (P1, P2, P3, . . .) of the address parts, and the data on the reference positions of the respective blocks for reading the lower significant digits is detected by the change of level of the output signal of the line sensor by the address part. Referring to Figure 3, the position of the elements of the photoelement part opposing the marker bit Im is detected and stored, thereby identifying the position of the element of the photoelement part on which each pattern constituting the address part is projected. Referring to Figure 3, it is seen that the pattern P1 of the binary number $2^0$ is projected on the ⑥ th and ⑦ th elements, and the pattern P2 of the binary number $2^1$ is projected on ⑩ th and ⑪ th elements. The addresses of the blocks are read in this embodiment as in the first embodiment. The above reading refers to the upper significant digit reading.

The reading of the lower significant digits is performed in the manner described below. For example, when the left end of the pattern P1 of the digit of the binary number $2^0$ is defined as the reference point of the block and all the points corresponding to level changes in the output signal of the line sensor after the detection of the marker bit Im are detected, level changes are detected on the ④ th, ⑥ th, ⑧ th, ⑭ th, and ⑯ th elements. The position of the marker bit Im is detected in advance, so that level change points between "0" and "1" (corresponding to transparent and opaque) within the block are detected by the ④ th, ⑥ th, ⑧ th, ⑭ and ⑯ th elements are identified. Thus, the address of the element corresponding to the reference point of the block which is preset may be obtained for each element at which the level changes in the output of the line sensor. For example, since the ④ th element is located to the right of the element at which the marker bit Im is detected by a distance corresponding to four elements, it is judged that it has detected the point of level change of the output signal at the right end of the marker M. Accordingly, it is seen that the position of the element corresponding to the reference point of the block is located to the right of the ④ th element by a distance corresponding to two elements, that is, the ⑥ th element. By performing similar operations for the ⑥ th, ⑧ th, ⑭ th, and ⑯ th elements, the data on the reference point of the block may be obtained under the condition shown in Figure 3. It thus becomes possible to improve the reliability of measurement by, for example, by obtaining a mean value from these five values or by separation or elimination of a particular point due to dust or noise. According to this method, when a greater number of elements of the line sensor correspond to each pattern of the address part (when the 2 elements corresponding to each of the patterns P1, P2, . . . P4 in Figure 3 is increased to a greater number), more or less incorrect detection of the marker bit lm due to deposition of dust on the code plate, the irregular sensitivity of the respective elements of the line sensor, and so on may not affect the readings of the codes unless the error is large enough to make an incorrect indication of the position of the pattern. This is because the marker bit lm is used only for indicating the rough positions of the patterns (P1, P2, ... P4) of the address part. The reading of the lower significant digits, that is, the reading employing the reference unit of the pitch of the elements of the photoelement part, is obtained from the distance between the reference position determined by statistical processing of several data and the index bit ln, so that reading may be performed with high precision and reliability.

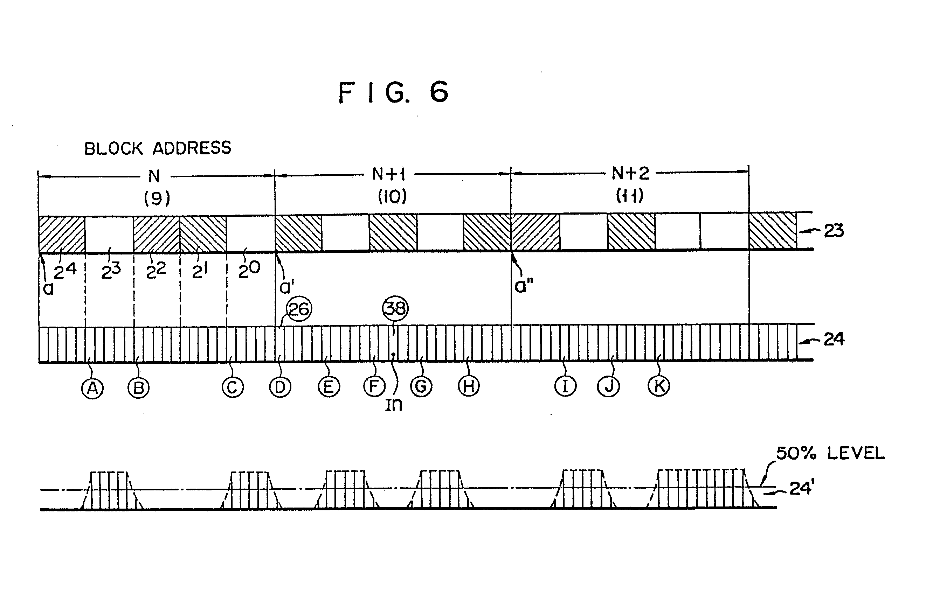

Figure 6 shows another embodiment of the present invention according to which each block does not include a particular marker pattern. Referring to this figure, reference numeral 23 denotes part of the code plate consisting only of a block address, 24 denotes the photoelement part of the line sensor arranged in opposition thereto, and 24' denotes an output of the line sensor. Each block address on the code plate is encoded with a 5-bit binary number ($2^0$, $2^1$, $2^2$, $2^3$, and $2^4$) and is encoded with a width corresponding to 5 elements of the photoelement part of the line sensor. Each block is encoded with consecutive binary numbers. Figure 6 shows a case wherein N=9. For detecting the relative displacement of the code plate and the line sensor in this embodiment, the binary codes encoded in each block are read as the upper significant digits, and as the lower significant digits the distances between the reference element (index bit ln) set at any position of the photoelement part and the predetermined reference positions (a, a', and a'', for example) of each block of the code plate are measured with the pitch of the photoelement part as the reference unit.

An example of the reading method will now be described in more detail. The output signal of the line sensor is binary-coded at a suitable level (e.g., 50% level) so that the output signal is represented by a code of "1" or "0". The first element with which the binary-value output changes from "0" (opaque part of the code plate) to "1" (transparent part of the code plate) or from "1" to "0" is detected (the Ⓐ th element in the figure). It is thus seen that the boundary between the binary bits representing the addresses is on the Ⓐ th element. However, it is not yet seen at this stage what digit of the binary number is projected at the boundary position of the bits. In order to identify it, the following process is performed. Due to the characteristics of binary numbers, consecutive numbers have the repeated patterns of "0", "1", and "0", or "1", "0", and "1" only in the case of the least significant bit (the bit of the digit of $2^0$). It is thus possible to indentify the position of the photoelement part on which the least significant bit is projected by checking the output signal of the line sensor for each block and identifying the position where it becomes (1, 0, 1) or (0, 1, 0). The address of the block may thus be read. Taking the Ⓐ th element as a reference, the output of the element one block to the right of this Ⓐ th element (to the right by 5×5=25 elements) and the output of the element two blocks to the right of the Ⓐ th element are detected to see if the output of either is (1, 0, 1) or (0, 1, 0). In order to check the output of the element of which the center of the respective bit of the binary number is projected, it is preferable to make the above judgment using as the reference the element which is two elements to the right of the Ⓐ th element. In order to eliminate the effects of dust on the code plate or the like, it is convenient not to judge the levels "0" and "1" with the output of the element corresponding to the above-mentioned position alone, but to examine the surrounding elements as well to make a judgment on the condition of each projected bit of the binary number. When a judgment of "YES" is made, it is seen that the least significant bit of the binary number is projected starting from the Ⓐ th element. When a judgment of "NO" is made, similar judgments are made using the element one bit to the right the binary number (5 elements to the right) as a reference until a judgment of "YES" is made. In the case of the example shown in the figure, the judgment of "YES" is made after four repetitions of the above-mentioned judgment so that Ⓐ th element is identified as the initial element of the digit of the binary number $2^3$, and the address of the block is read. The above description has been made with reference to the reading of the upper significant digits (block addresses).

The reading of the lower significant digits is performed for every point at which the level of the output signal of the line sensor changes. The addresses of the Ⓐ th, Ⓑ th, Ⓒ th, ... Ⓚ th elements are detected. Since the projected position of the least significant bit and the address of the block are known by the above process, it is seen that the Ⓐ th element is the initial element of the digit of $2^3$ of the block address N, and the Ⓑ th element is the initial element of the digit of $2^2$ of the block address N. Since the reference positions of the blocks are determined to be a, a', and a'' as shown in the figure, the position a is obtained from level change points Ⓐ to Ⓒ of the detected signals, the position a' is obtained from level change points Ⓓ to Ⓗ, and the position a'' is obtained from level change points Ⓘ to Ⓚ. Since a, a' and a'' are known to be separated by a distance of one block, that is, a distance corresponding to 25 elements, the reference position a' of the block including the index bit ln may be obtained by arithmetic operations from all the level change points of the signals (Ⓐ,... Ⓚ). Under the ideal conditions as shown in the figure, the detection result of the position a' by the point Ⓐ and the detection result by the point Ⓑ indicate the same value. Thus, under the condition shown in the figure, the position a' is indentified as on the ㉘ th element of the photoelement part.

However, in practice, these values include some variations due to dust on the code plate or the line sensor protective glass or the like, irregular sensitivity of the elements of the photoelement part, and so on. Therefore, it becomes possible to accomplish reading with high precision and reliability by obtaining a number of values and then obtaining the mean value, or by rejecting the particular point. Furthermore, according to this embodiment, the encoding density of the code plate may be improved and the manufacture of the code plate may be simplified without incorporating within each block a particular pattern representing the reference positions of the block. It is assumed that, in the case of the example shown in the figure, the mean value of the detected values of the position a' from the operation results of the points Ⓐ to Ⓚ is 25.8, the arbitrarily selected index bit In is the ㉚ th element, and the pitch of the elements of the photoelement part of the line sensor is 10 μm. In this case, since the address of the block incorporating the index bit In is "10" and each block corresponds to 25 elements, the relative displacement of the line sensor and the code plate may be detected as

$$\{(10-1)\times 25+(38-25.8)\}\times 10 \ \mu m=2{,}372 \ \mu m$$

where the consecutive numbers of the block addresses begin at 1.

The present invention is not limited to the particular embodiments described above. For example, the address information of the block may be encoded with binary codes or gray codes. Furthermore, redundancy (e.g., a parity bit or the like) may be added during the encoding so that detection and correction of errors during reading of the block address information may be performed. Furthermore, instead of the binary encoding with the light-dark pattern, ternary encoding, quaternary encoding an so on with a number of threshold values may be performed utilizing intermediate levels, thereby improving the encoding density.

In the embodiments described above, the light source and the CCD were held stationary and the scale was movable. However, another construction may be adopted according to which the scale and the light source are held stationary, and the CCD is movable. The pattern of the scale may be projected on the CCD as the reflected light image instead of the transmitting light image.

The present invention is also applicable to a magnetic encoder. In this case, the code plate is constructed according to the presence or absence of magnetic information, magnetic poles, or the presence or absence of magnetization or its associated poles. The line sensor may comprise a magnetic sensor array, for example a Hall element array of a pitch similar to that of the CCD Y of Figure 3. The principle of the present invention may be directly adopted if the code plate and the Hall element array are substantially in contact with each other.

**Claims**

1. A method of measuring an amount of relative movement between a code plate and a line sensor of an encoder device, said code plate having a plurality of blocks arranged along a direction of movement of said line sensor relative to said code plate, each of said blocks having a code pattern and marker information arranged along said relative movement direction, said code pattern being formed of a binary code of plural digits for designating an absolute address of the corresponding block, said line sensor having a plurality of sensor elements of equal width arranged in a line along said relative movement direction, and said sensor elements sensing said code pattern and marker information and producing an output in the form of a train of electrical signals, characterized in that said measuring method comprises:

a) a first step of detecting signals of said marker information from said train of signals;

b) a second step of detecting signals of said code pattern from said train of signals based on said marker information detected at said first step;

c) a third step of decoding said code pattern signals detected at said second step and determining the absolute address of the corresponding block;

d) a fourth step of detecting a predetermined reference position of the corresponding block based on a change in logic level of said code pattern signals;

e) a fifth step of calculating an amount of displacement between a predetermined index bit preset on said line sensor and said reference position detected at said fourth step, using said width of said sensor elements as a unit of length; and

f) a sixth step of calculating the amount of relative movement between said code plate and line sensor, using the absolute address determined at said third step as upper digits and the displacement amount calculated at the fifth step as lower digits.

2. A method of measuring an amount of relative movement between a code plate and a line sensor of an encoder device comprising a code plate and a line sensor, said code plate having at least three blocks arranged along a direction of movement of said line sensor relative to said code plate, each of said blocks having a code pattern arranged along said relative movement direction, said code pattern being formed of a binary code of plural digits for designating an absolute address of the corresponding block, said line sensor having a plurality of sensor elements of equal width arranged in a line along said relative movement direction, and said sensor elements sensing said code pattern and producing an output in the form of a train of electrical signals, characterized in that said measuring method comprises:

a) a first step of determining a place of at least one given digit common to the code patterns of said at least three blocks based on regularity in logic level of said given common digit;

b) a second step of determining places of other digits in said code patterns based on the place determined at said first step and decoding the absolute addresses of the blocks based on the places determined at the first and second steps;

c) a third step of detecting a predetermined reference position of the block based on a change in logic level of said train of signals;

d) a fourth step of calculating an amount of displacement between a predetermined index bit preset on said line sensor and said reference position detected at said third step, using said width of said sensor elements as a unit of length; and

e) a fifth step of calculating an amount of relative movement between said code plate and line sensor, using the absolute addresses determined at said second step as upper digits and the displacement amount calculated at the fourth step as lower digits.

3. A measuring method according to claim 2, characterized in that, at said first step, said common digit is determined as the least significant digit in each of said code patterns when the regularity is 1, 0, 1 or 0, 1, 0.

4. An encoder device comprising:

a line sensor (24);

a code plate (23) having at least three blocks ($N_{p-1}$, $N_p$, $N_{p+1}$) arranged along a direction of movement of said line sensor relative to said code plate, each of said blocks having a code pattern (P1, P2, P3, P4, ...) set along said relative movement direction, said code pattern being formed of a binary code of plural digits for designating an absolute address of the corresponding block, said line sensor having a plurality of sensor elements (F) of equal width arranged in a line along said relative movement direction, and said sensor elements (F) sensing said code pattern and producing an output in the form of a train (24') of electrical signals; and processing means (5, 6, 7, H) characterised in that said processing means includes

first means for determining a place of at least one given digit common to the code patterns of said at least three blocks based on regularity in logic level of said given common digit,

second means for determining places of other digits in said code patterns based on the place determined by said first means and decoding the absolute addresses of the blocks based on the places determined by the first and second means,

third means for detecting a predetermined reference position of the block based on a change in logic level of said train of signals,

fourth means for calculating an amount of displacement between a predetermined index bit present on said line sensor and said reference position detected by said third means, using said width of said sensor elements as a unit of length, and

fifth means for calculating an amount of relative movement between said code plate and line sensor, using the absolute addresses determined by said second means as upper digits and the displacement amount calculated by the fourth means as lower digits.

5. An encoder device according to claim 4, characterized in that said processing means (5, 6, 7, H) determines said common digit as the least significant digit in each of said code patterns when the regularity is 1, 0, 1 or 0, 1, 0.

**Patentansprüche**

1. Verfahren zum Messen des Betrages einer Relativbewegung zwischen einer Codeplatte und einem Zeilensensor eines Codiergeräts, wobei die Codeplatte eine Mehrzahl Blöcke aufweist, die in Richtung der Bewegung des Zeilensensors gegenüber der Codeplatte angoerdnet sind und jeder Block eine Codemuster- und Markeninformation in Richtung der Relativbewegung aufweist, wobei ferner das Codemuster aus einem Binärcode von mehrstelligen Zahlen zum Bezeichnen einer absoluten Adresse des entsprechenden Blocks besteht und der Zeilensensor eine Mehrzahl von Sensorelementen übereinstimmender Breite aufweist, die in einer Linie in Richtung der Relativbewegung angeordnet sind, und wobei schließlich die Sensorelemente die Codemuster- und Markeninformation abtasten und eine Ausgangsgröße in Form einer Folge von elektrischen Signalen erzeugen, dadurch gekennzeichnet, daß das Meßverfahren die folgenden Schritte umfaßt:

a) als ersten Schritt das Ermitteln von Signalen der Markeninformation aus der Signalfolge;

b) als zweiten Schritt das Ermitteln des Codemusters aus der Signalfolge, bezogen auf die im ersten Schritt ermittelte Markeninformation,

c) als dritten Schritt das Decodieren der Codemustersignale, die bei dem zweiten Schritt ermittelt worden sind, und das Bestimmen der absoluten Adresse des entsprechenden Blocks;

d) als vierten Schritt das Ermitteln einer vorbestimmten Bezugsposition des entsprechenden Blocks, bezogen auf eine Änderung der Logikebene der Codemustersignale;

e) als fünften Schritt das Errechnen eines Betrages der Verschiebung zwischen einem auf dem Zeilensensor voreingestellten vorbestimmten Indexbit und der beim vierten Schritt ermittelten Bezugsposition, wobei die Breite der Sensorelemente als Längeneinheit angewandt wird, und

f) als sechsten Schritt das Errechnen des Betrages der Relativbewegung zwischen der Codeplatte und dem Zeilensensor unter Verwendung der im dritten Schritt bestimmten absoluten Adresse als obere Zahlen und des im fünften Schritt errechneten Betrages der Verschießung als untere Zahlen.

2. Verfahren zum Messen des Betrages einer Relativbewegung zwischen einer Codeplatte und einem Zeilensensor eines Codiergeräts, wobei die Codeplatte mindestens drei Blöcke aufweist, die in Richtung der Bewegung des Zeilensensors gegenüber der Codeplatte angeordnet sind und jeder Block ein Codemuster in Richtung der Relativbewegung aufweist, wobei ferner das Codemuster aus einem Binärcode von mehrstelligen Zahlen zum Bezeichnen einer absoluten Adresse des entsprechenden Blocks besteht und der Zeilensensor eine Mehrzahl von Sensorelementen übereinstimmender Breite aufweist, die in einer Linie in Richtung der Relativbewegung angeordnet sind, und wobei schließlich die Sensorelemente des Codemuster abtasten und eine Ausgangsgröße in Form einer Folge von elektrischen Signalen erzeugen, dadurch gekennzeichnet, daß das Meßverfahren die folgenden Schritte umfaßt:

a) als ersten Schritt das Bestimmen eines Ortes von mindestens einer, den Codemustern der mindestens drei Blöcke gemeinsamen gegebenen Ziffer, bezogen auf Regularität in der Logikebene der gegebenen gemeinsamen Ziffer;

b) als zweiten Schritt das Bestimmen von Orten anderer Ziffern in den Codemustern, bezogen auf den durch den ersten Schritt bestimmten Ort, und das Decodieren der absoluten Adressen der Blöcke, bezogen auf die im ersten und im zweiten Schritt bestimmten Orte;

c) als dritten Schritt das Ermitteln einer vorbestimmten Bezugsposition des Blocks, bezogen auf eine Änderung der Logikebene der Signalfolge;

d) als vierten Schritt das Errechnen eines Betrags der Verschiebung zwischen einem auf dem Zeilensensor voreingestellten vorbestimmten Indexbit und der in dem dritten Schritt ermittelten Bezugsposition, wobei die Breite der Sensorelemente als Längeneinheit angewandt wird, und

e) als fünften Schritt das Errechnen eines Betrags der Relativbewegung zwischen der Codeplatte und dem Zeilensensor unter Verwendung der in dem zweiten Schritt bestimmten absoluten Adressen als obere Zahlen und des im vierten Schritt errechneten Betrags der Verschiebung als untere Zahlen.

3. Verfahren zum Messen nach Anspruch 2, dadurch gekennzeichnet, daß bei dem ersten Schritt die gemeinsame Ziffer als die niedrigstwertige Stelle in jedem der Codemuster bestimmt wird, wenn die Regularität 1, 0, 1 oder 0, 1, 0 ist.

4. Codiergerät mit:

einem Zeilensensor (24),

einer Codeplatte (23) mit mindestens drei Blöcken ($N_{p-1}$, $N_p$, $N_{p+1}$), angeordnet in Richtung der Bewegung des Zeilensensors gegenüber der Codeplatte, wobei jeder der Blöcke ein Codemuster (P1, P2, P3, P4, ...) aufweist, das in Richtung der Relativbewegung ausgerichtet ist, wobei das Codemuster aus einem Binärcode von mehrstelligen Zahlen zum Bezeichnen einer absoluten Adresse des entsprechenden Blocks besteht, wobei ferner der Zeilensensor eine Mehrzahl von Sensorelementen (F) übereinstimmender Breite aufweist, die in einer Linie in Richtung der Relativbewegung angeordnet sind, und wobei schließlich die Sensorelemente (F) das Codemuster abtasten und eine Ausgangsgröße in Form einer Folge (24') von elektrischen Signalen erzeugen, und mit

einer Verarbeitungseinrichtung (5, 6, 7 H), dadurch gekennzeichnet, daß die Verarbeitungseinrichtung umfaßt:

eine erste Einrichtung zum Bestimmen eines Ortes von mindestens einer den Codemustern der mindestens drei Blöcke gemeinsamen gegebenen Ziffer, bezogen auf Regularität in der Logikebene der gegebenen gemeinsamen Ziffer,

eine zweite Einrichtung zum Bestimmen von Orten anderer Ziffern in den Codemustern, bezogen auf den durch die erste Einrichtung bestimmten Ort, und zum Decodieren der absoluten Adressen der Blöcke, bezogen auf die von der ersten und der zweiten Einrichtung bestimmten Orte,

eine dritte Einrichtung zum Ermitteln einer vorbestimmten Bezugsposition des Blocks, bezogen auf eine Änderung der Logikebene der Signalfolge,

eine vierte Einrichtung zum Errechnen eines Betrags der Verschiebung zwischen einem auf dem Zeilensensor voreingestellten vorbestimmten Indexbit und der von der dritten Einrichtung ermittelten Bezugsposition, wobei die Breite der Sensorelemente als Längeneinheit angewandt wird, und

eine fünfte Einrichtung zum Errechnen eines Betrags der Relativbewegung zwischen der Codeplatte und dem Zeilensensor unter Verwendung der von der zweiten Einrichtung bestimmten absoluten Adressen als obere Zahlen und des von der vierten Einrichtung errechneten Betrags der Verschiebung als untere Zahlen.

5. Codiergerät nach Anspruch 4, dadurch gekennzeichnet, daß die Verarbeitungseinrichtung (5, 6, 7, H) die gemeinsame Ziffer als die niedrigstwertige Stelle in jedem der Codemuster bestimmt, wenn die Regularität 1, 0, 1 oder 0, 1, 0 ist.

**Revendications**

1. Procédé de mesure de l'amplitude d'un mouvement relatif entre une plaque de code et un capteur linéaire d'un dispositif codeur, ladite plaque de code portant plusieurs blocs disposés le long d'une direction de mouvement dudit capteur linéaire par rapport à ladite plaque de code, chacun desdits blocs portant une configuration de code et une information de marqueur disposée le long de ladite direction du mouvement relatif, ladite configuration de code étant formée d'un code binaire de plusieurs chiffres pour désigner une adresse absolue du bloc correspondant, ledit capteur linéaire comportant plusieurs éléments capteurs de même largeur disposés en une ligne le long de ladite direction du mouvement relatif et lesdits éléments capteurs détectant ladite configuration de code et les informations de marqueur et produisant une sortie sous la forme d'un train de signaux électriques, caractérisé en ce que ledit procédé de mesure comporte:

a) une première phase de détection de signaux desdites informations de marquer dans ledit train de signaux;

b) une seconde phase de détection de signaux de ladite configuration de code à partir dudit train de signaux sur la base desdites informations de marqueur détectés à ladite première phase,

c) une troisième phase de décodage desdits signaux de configuration de code détectés à ladite seconde phase et déterminant l'adresse absolue du bloc correspondant;

d) une quatrième phase de détection d'une position de référence déterminée du bloc correspondant sur la base d'un changement de niveau logique desdits signaux de configuration de code;

e) une cinquième phase de calcul d'une amplitude de déplacement entre un bit d'index prédéterminé, établi sur ledit capteur linéaire et ladite position de référence détectée à ladite quatrième phase en utilisant ladite largeur desdits éléments capteurs comme unités de longueur; et

f) une sixième phase de calcul de l'amplitude du mouvement relatif entre ladite plaque de code et le capteur linéaire en utilisant l'adresse absolue déterminée à ladite troisième phase comme des chiffres supérieurs et l'amplitude du déplacement calculée à la cinquième phase des chiffres inférieurs.

2. Procédé de mesure de l'amplitude d'un mouvement relatif entre une plaque de code et un capteur linéaire d'un dispositif codeur comportant une plaque de code et un capteur linéaire, ladite plaque de code portant au moins trois blocs disposés suivant la direction du mouvement dudit capteur linéaire par rapport à ladite plaque de code, chacun desdits blocs comportant une configuration de code disposée suivant la direction du mouvement relatif, ladite configuration de code étant formée d'un code binaire de plusieurs chiffres pour désigner une adresse absolue du bloc correspondant, ledit capteur linéaire comportant plusieurs éléments capteurs de même largeur disposés en une ligne le long de la direction dudit mouvement relatif, et lesdits éléments capteurs détectant ladite configuration de code et produisant une sortie sous la forme d'un train de signaux électriques, caractérisé en ce que ledit procédé de mesure comporte:

a) une première phase de détermination d'une place d'au moins un chiffre donné commun aux configurations de code desdits au moins trois blocs sur la base de la régularité d'un niveau logique dudit chiffre commun donné;

b) une seconde phase de détermination des places d'autres chiffres dans lesdites configurations de code sur la base de la place déterminée par ladite première phase et de décodage des adresses absolues des blocs sur la base des places déterminées à la première et la seconde phases;

c) une troisième phase de détection d'une position de référence prédéterminée du bloc sur la base d'un changement de niveau logique du train de signaux;

d) une quatrième phase de calcul d'une amplitude du déplacement entre un bit d'index prédéterminé établi sur ledit capteur linéaire et ladite position de référence détectée à ladite troisième phase, en utilisant ladite largeur desdits éléments capteurs comme une unité de longueur; et

e) une cinquième phase de calcul d'une amplitude du mouvement relatif entre ladite plaque de code et le capteur linéaire en utilisant les adresses absolues déterminées à ladite seconde phase comme des chiffres supérieurs et l'amplitude de déplacement calculée à la quatrième phase comme des chiffres inférieurs.

3. Procédé de mesure selon la revendication 2, caractérisé en ce que, à ladite première phase, ledit chiffre commun est déterminé comme le chiffre le moins significatif dans chacune desdites configurations de code quand la régularité est 1, 0, 1 ou 0, 1, 0.

4. Dispositif codeur comprenant:

un capteur linéaire (24),

une plaque de code (23) comportant au moins trois blocs ($N_{p-1}$, $N_p$, $N_{p+1}$) disposés suivant une direction du mouvement dudit capteur linéaire par rapport à ladite plaque de code, chacun desdits blocs comportant une configuration de code (P1, P2, P3, P4. . .) établis le long de ladite direction du mouvement relatif, ladite configuration de code étant formée d'un code binaire de plusieurs chiffres pour désigner une adresse absolue du bloc correspondant, ledit capteur linéaire comportant plusieurs éléments capteurs (F) de même largeur disposés en une ligne le long de ladite direction du mouvement relatif et lesdits éléments capteurs (F) détectant ladite configuration de code et produisant une sortie sous la forme d'un train (24') de signaux électriques et

un dispositif de traitement (5, 6, 7, H), caractérisé en ce que ledit dispositif de traitement comporte:

un premier dispositif pour déterminer une position d'au moins un chiffre donné commun aux configurations de code desdits au moins trois blocs sur la base d'une régularité de niveau logique dudit chiffre commun donné,

un second dispositif pour déterminer les places d'autres chiffres dans lesdites configurations de code sur la base de la place déterminée par ledit premier dispositif et pour décoder les adresses absolues des blocs sur la base des places déterminées dans le premier et le second dispositifs;

un troisième dispositif pour détecter une position de référence prédéterminée du bloc sur la base d'un changement de niveau logique dudit train de signaux,

un quatrième dispositif pour calculer une amplitude de déplacement entre un bit d'index prédéterminé établi sur ledit capteur linéaire et ladite position de référence détectée par ledit troisième dispositif en utilisant ladite largeur des éléments capteurs comme une unité de longueur et,

un cinquième dispositif pour calculer une amplitude de mouvements relatifs entre la dite plaque de code et le capteur linéaire en utilisant les adresses absolues déterminées par ledit second dispositif comme des chiffres supérieurs et l'amplitude de déplacement calculée par le quatrième dispositif comme des chiffres inférieurs.

5. Dispositif codeur selon la revendication 4, caractérisé en ce que ledit dispositif de traitement (5, 6, 7, H) détermine ledit chiffre commun comme le chiffre le moins significatif dans chacune des configurations de code quand la régularité est 1, 0, 1 ou 0, 1, 0.

# F I G. 1

# F I G. 2A   z

# F I G. 2B   ø1

# F I G. 2C   ø2

# F I G. 2D   cō

F I G. 3

0 039 921

F I G. 4

FIG. 5

$$\text{START}$$

f1  SET ADDRESS POINTER

f2  PULSE PS→"0"→"1"→"0"

f3  A/D CONTROL AC→"0"

f4  A/D CONVERSION END AE="0"   NO / YES

f5  MEMORY ← A/D OUTPUT DATA

f6  A/D CONTROL AC ← "1"

f7  PULSE P2→"0"→"1"→"0"

f8  INCREASE ADDRESS POINTER BY "1"

f9  MS = X + (SBA)   NO / YES

f10  DATA MEMORY DM1←MARKER DETECTION VALUE

f11  DATA MEMORY DM2←ADDRESS DETECTION VALUE

f12  DISPLAY DEVICE←m(NSDM2 - DM1)

DISPLAY

4

# FIG. 6

BLOCK ADDRESS

50% LEVEL

0 039 921